# EUROPEAN PATENT APPLICATION

(11) **EP 4 478 478 A1**
(43) Date of publication of application: **18.12.2024**
(21) Application number: 24174957.1
(22) Date of filing: 08.05.2024
(51) Int. Cl.: H01M 10/44, H02J 7/00, G01R 31/36, G01R 31/382

(54) **BATTERY SYSTEM INCLUDING A CONTROL DEVICE WHICH EXECUTES POLARIZATION CANCELLATION OF A BATTERY**

(30) Priority: 12.06.2023 JP 2023095960
(71) Applicant: TOYOTA JIDOSHA KABUSHIKI KAISHA, Aichi-ken 471-8571 (JP)
(72) Inventor: HAGIWARA, Hideki, Toyota-shi, 471-8571 (JP); NAGASE, Hiroshi, Toyota-shi, 471-8571 (JP); OGUMA, Yasumasa, Toyota-shi, 471-8571 (JP); YOSHIDA, Jun, Toyota-shi, 471-8571 (JP); MIGITA, Tsubasa, Toyota-shi, 471-8571 (JP); UCHIDA, Yoshihiro, Toyota-shi, 471-8571 (JP)
(74) Representative: D Young & Co LLP

(57) **Abstract**

A battery system includes a battery and an ECU. The ECU executes polarization cancellation control for canceling polarization of the battery and calculation processing for calculating SOC of the battery after the polarization cancellation control. When the polarization cancellation control is executed after the battery is discharged, the polarization cancellation control is charging control for charging the battery. When the polarization cancellation control is executed after the battery is charged, the polarization cancellation control is discharging control for discharging the battery.

## Description

### BACKGROUND OF THE INVENTION

### 1. Field of the Invention

The present disclosure relates to a battery system.

### 2. Description of Related Art

Japanese Unexamined Patent Application Publication No. 2019-160721 discloses a battery system including a secondary battery.

### SUMMARY OF THE INVENTION

When a power storage device such as a secondary battery is appropriately protected or fully used, it is important to calculate SOC (State Of Charge) of the power storage device with high accuracy. Therefore, a technique that improves the calculation accuracy of SOC is desired.

The present disclosure has been made to solve the problem, and has an object to provide a battery system that can improve the calculation accuracy of SOC.

The battery system of the present disclosure includes a power storage device and a control device. The control device executes polarization cancellation control for canceling polarization of the power storage device, and calculation processing for calculating SOC of the power storage device after the polarization cancellation control. When the polarization cancellation control is executed after the power storage device is discharged, the polarization cancellation control is charging control for charging the power storage device. When the polarization cancellation control is executed after the power storage device is charged, the polarization cancellation control is discharging control for discharging the power storage device.

Since the polarization of the power storage device changes the voltage of the power storage device, the polarization may affect an SOC calculation result. The polarization of the power storage device is canceled by application of a voltage having a polarity opposite to that of the power storage device. Specifically, the polarization of the power storage device after the power storage device has been discharged is canceled by charging the power storage device, and polarization after charging is canceled by discharging. With the configuration, even if polarization occurs, SOC is calculated after the polarization is canceled by the polarization cancellation control. This makes it possible to avoid a situation where a calculation result of SOC is influenced by polarization. As a result, SOC can be calculated with high accuracy.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a diagram schematically showing an overall configuration of a vehicle equipped with a battery system according to an embodiment;
FIG. 2A is a diagram schematically showing a configuration of each cell of a battery;
FIG. 2B is a diagram schematically showing the configuration of each cell of the battery;
FIG. 3 is a diagram showing an example of a curve line representing SOC-OCV (Open Circuit Voltage) characteristics of a battery;
FIG. 4A is a diagram showing that the polarization of a battery 10 can affect the calculation accuracy of SOC;
FIG. 4B is a diagram showing that the polarization of the battery 10 can affect the calculation accuracy of SOC;
FIG. 5 is a diagram specifically showing SOC calculation processing when a full charge capacity of the battery 10 is estimated by ECU (Electronic Control Unit); and
FIG. 6 is a flowchart illustrating processing to be executed by ECU in connection with the SOC calculation processing.

### DETAILED DESCRIPTION OF EMBODIMENTS

Hereinafter, embodiments of the present disclosure will be described in detail with reference to the drawings. Identical or corresponding portions in the figures are designated by the same reference signs, and the description thereof will not be repeated.

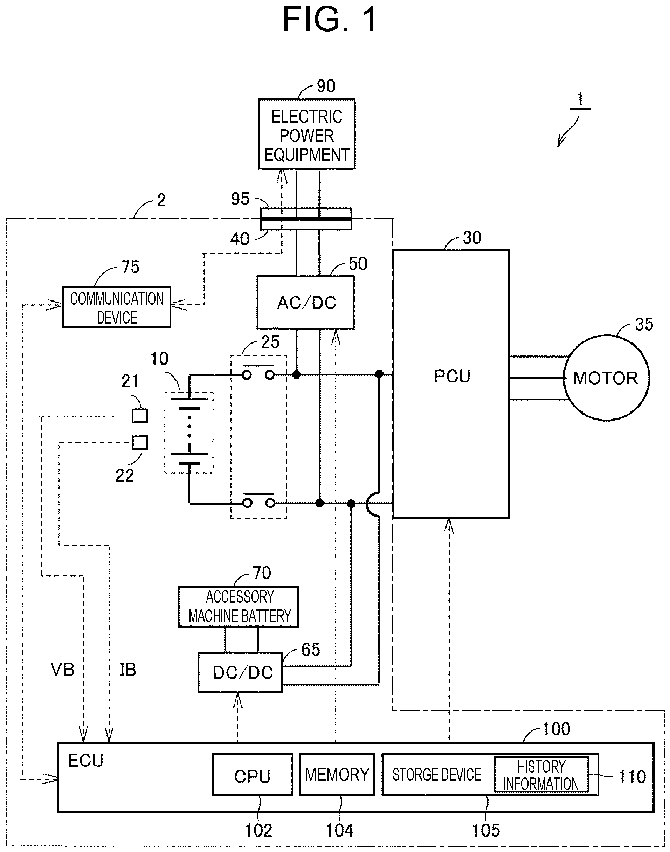

FIG. 1 is a diagram schematically showing an overall configuration of a vehicle equipped with a battery system according to an embodiment. Referring to FIG. 1, a vehicle 1 is a battery electric vehicle (BEV), and is configured to be capable of performing external charging for charging a battery 10 by using electric power supplied from electric power equipment 90 on the outside of the vehicle 1.

The vehicle 1 further includes the battery 10, a voltage sensor 21, a current sensor 22, an SMR (System Main Relay) 25, a PCU (Power Control Unit) 30, and a motor 35. The vehicle 1 further includes an inlet 40, an AC/DC converter 50, a DC-DC converter 65, an accessory machine battery 70, a communication device 75, and an ECU 100. The battery 10, the voltage sensor 21, the current sensor 22, the SMR 25, the AC/DC converter 50, the DC-DC converter 65, the accessory machine battery 70, the communication device 75, and the ECU 100 constitute a battery system 2.

The battery 10 is an example of a power storage device, and stores electric power for driving the vehicle 1. The battery 10 is an assembled battery including a plurality of cells. Each cell is a secondary battery, and is an all-solid-state battery in this example. The all-solid-state battery means a battery having a solid electrolyte layer.

After the battery 10 is charged or discharged, polarization of battery 10 may occur. Polarization is a phenomenon in which when a current flows through the battery 10, an electromotive force (polarization voltage) in a direction opposite to that of the current occurs temporarily. In other words, polarization is a phenomenon in which the voltage VB temporarily increases when the battery 10 is charged or the voltage VB temporarily decreases when the battery 10 is discharged. Polarization disappears naturally when a sufficiently long period of time has elapsed after charging or discharging, or disappears when a voltage in a direction opposite to that of the polarization voltage is applied to the battery 10 (the polarization voltage becomes zero and the voltage VB becomes stable).

The voltage sensor 21 detects the voltage VB of the battery 10. The current sensor 22 detects a current IB flowing through the battery 10. The current IB under charging is positive, and the current IB under discharging is negative.

The SMR 25 is connected between the battery 10 and the PCU 30. The PCU 30 performs bidirectional power conversion between the battery 10 and the motor 35. The motor 35 is an AC rotating electric machine, and generates driving force for the vehicle 1 during power running. The motor 35 can also perform regenerative power generation when the vehicle 1 is braked or acceleration on a downhill slope is reduced. During regenerative power generation by the motor 35, the generated power is supplied to the battery 10 through the PCU 30 to charge the battery 10.

The inlet 40 is configured such that a connector 95 of the electric power equipment 90 can be inserted thereinto, and receives power supplied from the electric power equipment 90. In this example, the supply power is AC power. The AC/DC converter 50 converts the power received by the inlet 40 into DC power for charging the battery 10. The AC/DC converter 50 can also convert the power of the battery 10 into AC power, and supply the power to the electric power equipment 90 via the inlet 40. The power supply from the vehicle 1 to electric power equipment 90 is also referred to as "external power supply". During external power supply, the battery 10 is discharged.

The DC-DC converter 65 is connected to the accessory machine battery 70. The accessory machine battery 70 stores electric power for operating various accessory machines (not shown) of the vehicle 1. The communication device 75 exchanges various information with the electric power equipment 90, for example, by CAN (Controller Area Network) communication. This information includes information indicating the amount of electric power transmitted between the vehicle 1 and the electric power equipment 90 during external charging or external power supply, the start/stop of external charging, or the start/stop of external power supply.

The ECU 100 includes a CPU (Central Processing Unit) 102, a memory 104, and a storage device 105. The CPU 102 executes various calculation processing. The memory 104 includes an ROM (Read Only Memory) and a RAM (Random Access Memory). The ROM stores programs to be executed by the CPU 102 and various data. The data includes information indicating characteristic representing the relationship between SOC and OCV of the battery 10. This characteristic is also called an SOC-OCV characteristic. This characteristic is used to calculate SOC according to OCV, and is influenced by a charge/discharge history (hysteresis) of the battery 10. The OCV is defined as the voltage VB when the SMR 25 is turned off. The storage device 105 stores a charge/discharge history 110 representing the history of the voltage VB and the current IB.

The ECU 100 controls various devices of the vehicle 1 and calculates the SOC of the battery 10 based on signals received from respective sensors of a monitoring unit 20 and programs and maps stored in the memory 104. This device includes the SMR 25, the PCU 30, the AC/DC converter 50, the DC-DC converter 65, and the communication device 75. When the SMR 25 is turned on, the ECU 100 controls charging and discharging of the battery 10 by using the PCU 30. The ECU 100 drives the motor 35 by controlling the PCU 30. The ECU 100 is configured to be capable of executing control (pumping charging control) for controlling the DC-DC converter 65 so as to supply electric power of the accessory machine battery 70 to the battery 10.

The ECU 100 is configured to be capable of executing external charging control for controlling external charging and external power supply control for controlling external power supply. These control operations are executed by using the AC/DC converter 50 and the communication device 75. The ECU 100 is configured to be capable of estimating a full charge capacity of the battery 10 by dividing the charging amount of the battery 10 by an SOC increment (ΔSOC) when the battery 10 is charged. The charging amount of the battery 10 is determined based on an integration value of the current IB.

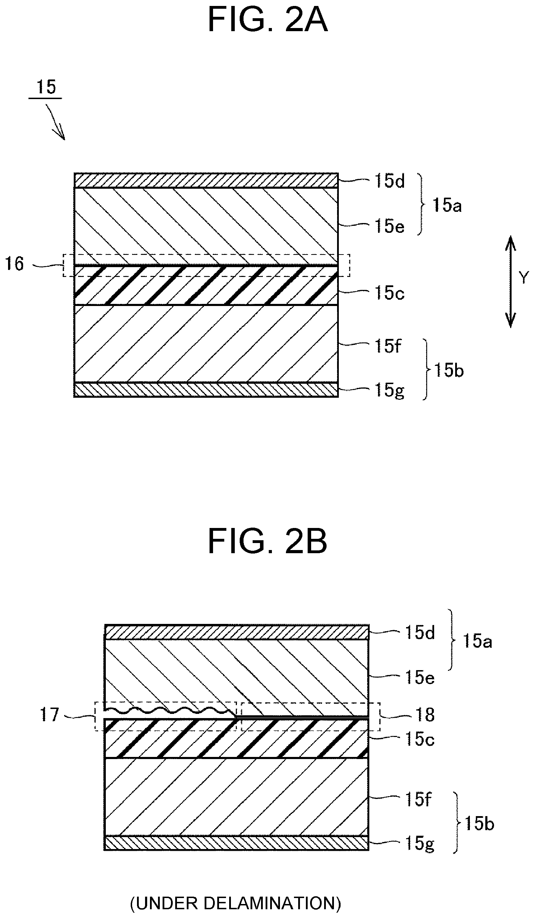

FIGS. 2A and 2B are diagrams schematically showing a configuration of each cell of the battery 10. Referring to FIGS. 2A and 2B, the cell 15 includes a positive electrode layer 15a, a negative electrode layer 15b, and a solid electrolyte layer 15c.

The positive electrode layer 15a includes a positive electrode active material layer 15d and a positive electrode current collector 15e. The positive electrode active material layer 15d contains lithium cobalt oxide, lithium nickel oxide, or lithium iron phosphate. The positive electrode active material layer 15d is joined to the solid electrolyte layer 15c, and is in close contact with the solid electrolyte layer 15c in the example of FIG. 2A. A region 16 is a junction region of these layers. The negative electrode layer 15b includes a negative electrode active material layer 15f and a negative electrode current collector 15g. The negative electrode active material layer 15f contains a metal active material or a carbon active material. The negative electrode active material layer 15f is joined to the solid electrolyte layer 15c, and is in close contact with the solid electrolyte layer 15c in this example. The solid electrolyte layer 15c is interposed between the positive electrode layer 15a and the negative electrode layer 15b. The positive electrode layer 15a, the solid electrolyte layer 15c, and the negative electrode layer 15b are stacked in a direction in which a plurality of cells 15 is stacked (Y direction).

When charging and discharging of the all-solid-state battery is repeated, a part of the joint between the electrode layer such as the positive electrode layer 15a and the solid electrolyte layer 15c may peel off (FIG. 2B). Such a phenomenon is also called delamination. Regions 17 and 18 are a non-joint region and a joint region between the electrode layer (in this example, the positive electrode layer 15a) and the solid electrolyte layer under delamination, respectively. Under delamination, the electrical resistance of region 17 is high and the electrical resistance of region 18 is low. Such non-uniformity of electrical resistance affects diffusion of charge carriers and tends to lead to non-uniformity in electron density. As a result, in the all-solid-state battery, lithium salts and the like are easily diffused and thus polarization occurs easily. Furthermore, under delamination, a large current tends to flow in the all-solid-state battery due to the low electrical resistance of the region 18. When the all-solid-state battery is charged with a large current (overcharged) and then immediately discharged, a large amount of discharge current flows into the region 18. As a result, the all-solid-state battery is discharged with a large current, and the polarization after charging is immediately canceled.

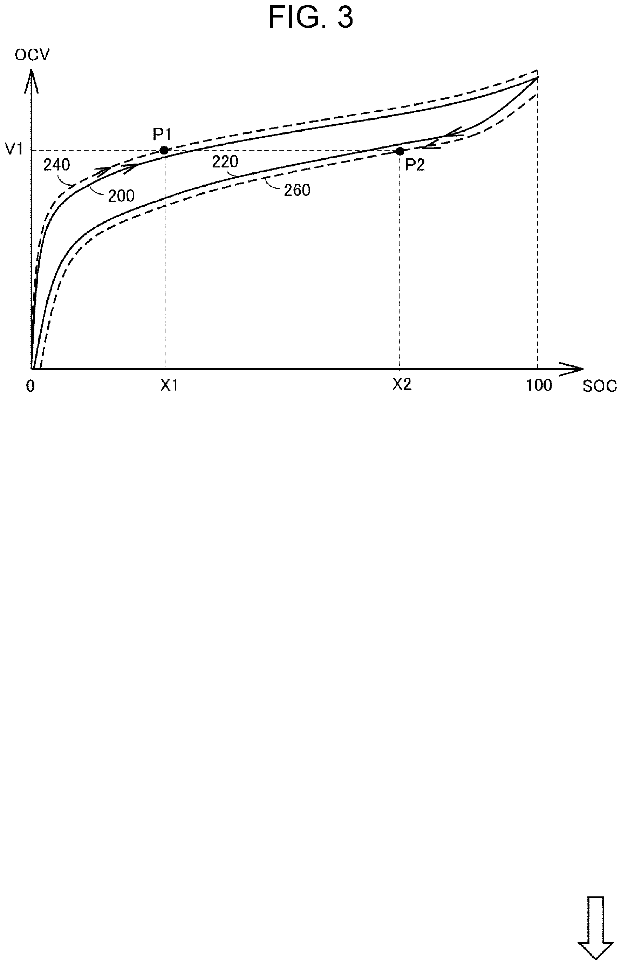

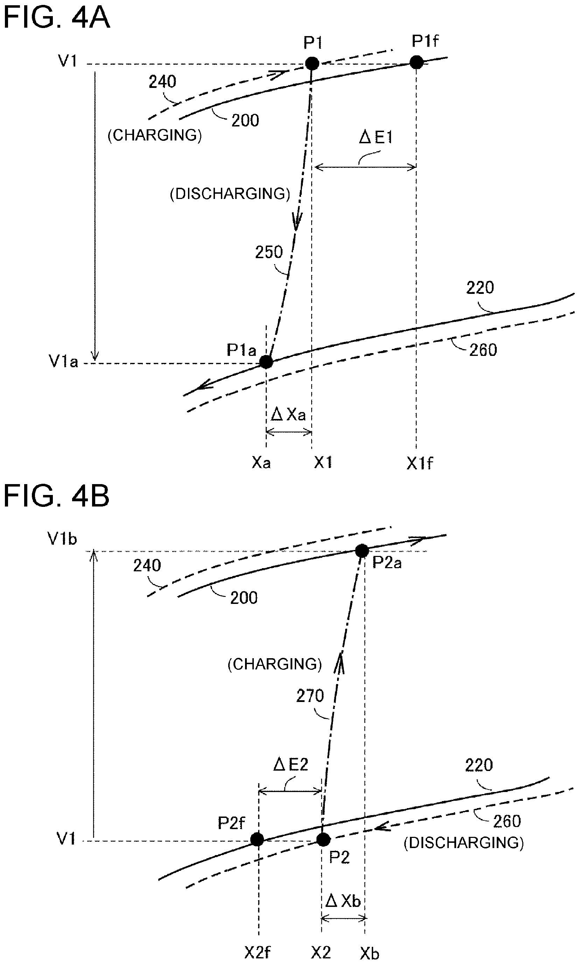

FIG. 3 is a diagram showing an example of a curve line representing the SOC-OCV characteristic of the battery 10. FIGS. 4A and 4B are diagrams showing that the polarization of the battery 10 can affect the calculation accuracy of the SOC.

Referring to FIG. 3, a line 200 indicates an example of the SOC-OCV characteristic when battery 10 is charged. In this example, the characteristic corresponds to an SOC-OCV characteristic when the battery 10 has been charged from a fully discharged state to a fully charged state. The Line 200 is also referred to as a "charging curve line". A line 220 indicates an example of the SOC-OCV characteristic when battery 10 is discharged. In this example, the characteristic corresponds to an SOC-OCV characteristic when the battery 10 has been discharged from a fully charged state to a fully discharged state. The line 220 is also referred to as a "discharging curve line". In this way, the SOC-OCV characteristic differ depending on the charge/discharge history (hysteresis). Each of the lines 200 and 220 shows the SOC-OCV characteristic under the condition that polarization of the battery 10 has not occurred (or has been canceled).

A line 240 indicates an example of the SOC-OCV characteristic when the battery 10 has been charged from a fully discharged state to a fully charged state; the line 240 differs from the line 200 in that the line 240 represents a characteristic under a situation where polarization occurs. A line 260 indicates an example of the SOC-OCV characteristic when the battery 10 has been charged from a fully charged state to a fully discharged state; the line 260 differs from the line 220 in that the line 260 represents a characteristic under a situation where polarization has occurred. In this way, the SOC-OCV characteristic changes under the influence of polarization in addition to the influence of hysteresis. In this example, each of the lines 200 and 220 is stored in the memory 104, but each of the lines 240 and 260 is not stored in the memory 104.

Points P1 and P2 are points on the lines 240 and 260 respectively for V1. Each of the points P1 and P2 corresponds to an operating point when OCV is V1 and polarization is occurring.

Referring to FIGS. 4A and 4B, the polarization of the battery 10 can affect the calculation accuracy of the SOC of the battery 10. For example, when OCV is V1 under charging, polarization may actually occur, so that it may happen that the actual operating point is point P1 and the actual SOC is X1 (FIG. 4A). However, since the charging curve line stored in the memory 104 is not the line 240, but the line 200, there is a possibility that the operating point is incorrectly determined to be a point P1f based on the line 200, and the SOC is calculated as X1f. As a result, the calculation result of SOC includes an error of ΔE1. Likewise, when polarization has occurred under discharge, there is a possibility that the operating point is incorrectly determined to be point P2f based on the line 220 even though the actual operating point is point P2 (SOC is X2), and SOC is calculated as X2f (FIG. 4B). As a result, the calculation result of SOC may include an error of ΔE2. In this way, polarization tends to cause deterioration in the calculation accuracy of SOC. In particular, in the all-solid-state battery, polarization is likely to occur due to delamination (FIGS. 2A and 2B), so that there is a need for a technique to avoid deterioration in SOC calculation accuracy due to polarization.

The inventors have focused on the fact that when polarization occurs, the calculation accuracy of SOC can be enhanced by canceling the polarization and calculating the SOC after the polarization is canceled. Polarization is canceled by applying a voltage having a polarity opposite to that of the polarization. Specifically, polarization after discharging is canceled by charging, and polarization after charging is canceled by discharging.

In the present embodiment, the ECU 100 executes the polarization cancellation control for canceling the polarization of the battery 10 and the calculation processing for calculating the SOC of the battery 10 after the polarization cancellation control. When the polarization cancellation control is executed after the battery 10 is charged, the polarization cancellation control is discharging control for discharging the battery 10. This control may be control to be executed using the PCU 30 while the vehicle 1 is running, or may be external power supply control. When the polarization cancellation control is executed after the battery 10 is discharged, the polarization cancellation control is charging control for charging the battery 10. This control may be control to be executed using the PCU 30 while the vehicle 1 is running, or may be external charging control.

According to the calculation processing, even when polarization has occurred, the polarization is canceled by the polarization cancellation control, and then the SOC is calculated. This makes it possible to avoid a situation where the calculation result of SOC is influenced by polarization. Furthermore, since polarization is canceled by the polarization cancellation control before the polarization is naturally canceled after a sufficiently long period of time has elapsed, the SOC can be calculated at an early stage.

The ECU 100 uses the SOC-OCV characteristic (the lines 200, 220) stored in the memory 104 to execute the calculation processing of SOC according to the OCV of the battery 10. For example, when the discharging control is performed as the polarization cancellation control after the battery 10 is charged, the calculation processing corresponds to the processing of calculating SOC using the line 220 (discharging curve line). For example, when the OCV at the start time of this discharging control is V1, the operating point of the battery 10 changes from the point P1 to the point P1a via a line 250 (OCV decreases from V1 to V1a) due to discharging control, and then changes on the line 220 (FIG. 4A). The line 250 is not stored in the memory 104. After the discharging control, the ECU 100 calculates the SOC according to the OCV by using the line 220. For example, when the OCV after the discharging control is V1a, the calculation result of SOC is Xa. Xa is lower than X1 by ΔXa.

When charging control is performed as the polarization cancellation control after the battery 10 is discharged, the calculation processing corresponds to the processing of calculating SOC using the line 200 (charging curve line). For example, when OCV at the start time of this charging control is V1, the operating point changes from the point P2 to the point P2a via a line 270 (the OCV increases from V1 to V1b) due to the charging control, and then changes on the line 200 (FIG. 4B). The line 270 is not stored in the memory 104. After the charging control, the ECU 100 calculates SOC according to OCV by using the line 200. For example, when OCV after the charging control is V1b, a calculation result of SOC is Xb. Xb is higher than X2 by ΔXb.

According to the polarization cancellation control, the battery 10 is discharged after charged, or the battery 10 is charged after discharged, thereby canceling polarization. As a result, SOC is calculated in a state where polarization has been canceled (a state where the operating point is on the line 200 or 220), so that it is possible to avoid deterioration in the calculation accuracy of SOC caused by polarization.

Note that it is preferable that a period of time during which the polarization cancellation control is executed (hereinafter also referred to as "polarization cancellation period") is appropriately short. This is to avoid a situation where a polarization voltage in a direction opposite to that of an original polarization voltage is newly generated due to this control.

When the battery 10 is discharged just before the polarization cancellation period (specifically, the start time thereof), the period of time during which the battery 10 is discharged as described above is also referred to as "just-before discharging period". When the battery 10 is charged just before the polarization cancellation period, the period of time during which the battery 10 is charged as described above is also referred to as "just-before charging period". "Just before the polarization cancellation period" basically (if the period is shorter than a predetermined upper limit described below) means a period of time nearest to the current time out of a charging period (a period of time during which the battery 10 is charged) and a discharging period (a period of time during which the battery 10 is discharged) before this control is started. This period of time corresponds to a period of time from a time when charging/discharging of the battery 10 was last switched (a time when the positive/negative signs of the current IB was last switched) until the current time. If the length of this period of time is longer than a predetermined upper limit (for example, 3 minutes), "just before the polarization cancellation period" (just-before charging period or just-before discharging period) is defined as a period of time having the length of the predetermined upper limit. Information on the charging period and discharging period is generated based on the current IB, and stored in the memory 104.

The polarization cancellation period after charging is shorter than the just-before charging period. Likewise, the polarization cancellation period after discharging is shorter than the just-before discharging period. If the polarization cancellation period is excessively long, it can be assumed that a polarization voltage in a direction opposite to that of the original polarization voltage is newly generated. However, in the present embodiment, since the polarization cancellation period is short, the situation described above can be avoided.

Furthermore, since the calculation processing of SOC is executed after the polarization cancellation control, the calculation processing is started more early as the polarization cancellation period is shorter. In the present embodiment, since the polarization cancellation period is short, the polarization cancellation control during this period of time is completed in a short time. As a result, SOC can be calculated quickly.

It is also not preferable that the polarization cancellation period is excessively short. In this case, there is a possibility that polarization is not sufficiently canceled. Additionally, there is a possibility that SOC is calculated at a timing before the operating point changes from the point P1 (FIGS. 4A and 4B) to a point on the line 220 (for example, the point P1a) or before the operating point changes from the point P2 to a point on the line 200 (for example, the point P2a) (that is, while the operating point is shifting on the line 250 or 270). Since the memory 104 stores the lines 200 and 220, but does not store the lines 250 and 270, SOC calculated at the timing may be inaccurate.

The inventors have experimentally obtained a knowledge that if the length of the polarization cancellation period is one eleventh or more and one ninth or less (hereinafter also referred to as "about one tenth") of the length of the just-before discharging period or just-before charging period, polarization is sufficiently canceled and a polarization voltage in a direction opposite to that of the original polarization voltage is difficult to be generated. Specifically, by setting the length of the polarization cancellation period in this way, the operating point could be changed from the points P 1, P2 to points on the lines 220, 200, respectively (more specifically, points P1a, P2a or points near them). Therefore, in the present embodiment, when the polarization cancellation control (charging control) is executed after the battery 10 is discharged, the length of the polarization cancellation period is set to about one tenth of the length of the just-before discharging period. Likewise, when the polarization cancellation control (discharging control) is executed after the battery 10 is charged, the length of the polarization cancellation period is set to about one tenth of the length of the just-before charging period. In this way, the length of the polarization cancellation period is basically longer as the length of the just-before charging period or just-before discharging period is longer.

When the length of the polarization cancellation period is shorter than one eleventh of the length of the just-before charging period or just-before discharging period, there is a possibility that the polarization is not be sufficiently canceled or SOC is calculated while the operating point is shifting on the line 250 or 270, which causes deterioration in calculation accuracy of SOC. When the length of the polarization cancellation period is longer than one ninth of the length of the just-before charging period or just-before discharging period, a polarization voltage in a direction opposite to that of the original polarization voltage is newly generated, which may cause deterioration in calculation accuracy of SOC calculation. In contrast, the present embodiment can avoid such a problem.

When the just-before charging period or the just-before discharging period is defined as a period having the length of the upper limit, the length of the polarization cancellation period is set (limited) to be equal to about one tenth of the upper limit. Otherwise, the length of the polarization cancellation period is set to about 1/10 of the length of the just-before charging period or the just-before discharging period. As a result, even when the battery 10 is charged or discharged for a long time before the polarization cancellation control, it is possible to avoid a situation where the polarization cancellation period is excessively long, so that the calculation of SOC is delayed.

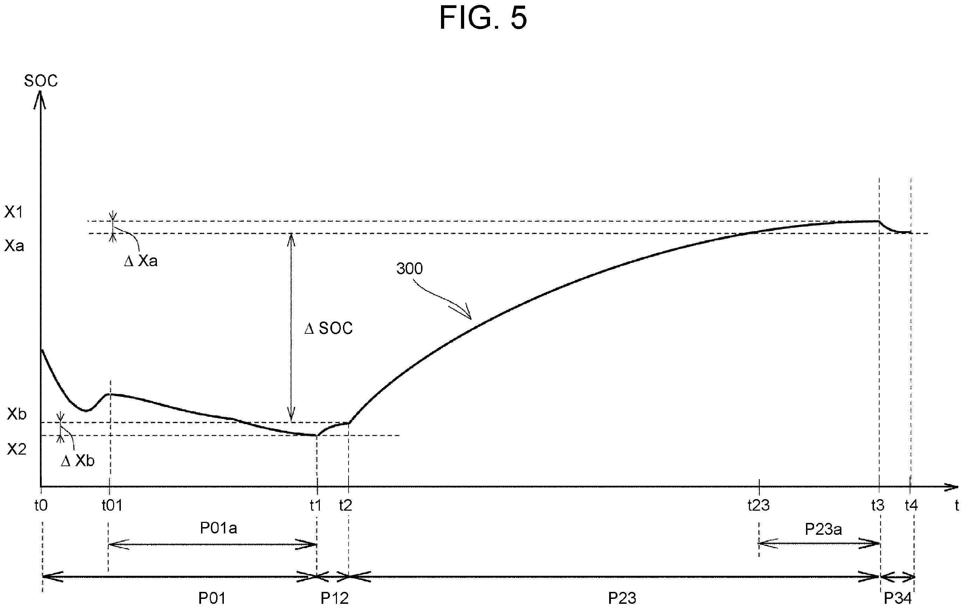

FIG. 5 is a diagram specifically showing the calculation processing of SOC when the full charge capacity of the battery 10 is estimated by the ECU 100. Referring to FIG. 5, a line 300 represents an example of transition of SOC.

During the period of time from time t0 to time t1 (the period of time P01), the vehicle 1 is running, and the battery 10 is charged or discharged. At time t1, the vehicle 1 is connected to the electric power equipment 90 via the inlet 40 (plug-in). The period of time from time t01 to time t1 (the period of time P01a) is the just-before discharging period. It is assumed that polarization occurs at time t1.

At time t1, ECU 100 determines based on a charge/discharge history 110 that the battery 10 has been discharged during the period of time P01a. Based on this determination result, the ECU 100 executes the charging control as the polarization cancellation control during the period of time from time t1 to time t2 (a period of time P12). This control is external charging control. The period of time P12 is a polarization cancellation period when the polarization cancellation control is executed after the battery 10 is discharged. During the period of time P12, the ECU 100 performs the external charging control so that the charging electric power of the battery 10 becomes minute electric power. In this example, the length of the period of time P12 is one tenth of the period of time P01a (the just-before discharging period).

At time t2, the ECU 100 stops external charging control in which charging electric power is minute electric power, and calculates SOC. Thereafter, during the period of time from time t2 to time t3 (period of time P23), the external charging control is performed so that the charging electric power is larger than the charging electric power during the period of time P12.

At time t3, the ECU 100 stops external charging control. The period of time from time t23 to time t3 (a period of time P23a) is the just-before charging period. In this example, since the length of the period of time from the time when charging/discharging of the battery 10 was last switched until the current time is longer than the upper limit, the period of time P23a (just-before charging period) is a period having the length of the upper limit. It is assumed that polarization occurs at time t3.

The ECU 100 determines based on the charge/discharge history 110 that the battery 10 has been charged during the period of time P23a. Based on this determination result, the ECU 100 executes discharging control as the polarization cancellation control during the period of time from time t3 to time t4 (a period of time P34). This control is external power supply control. The period of time P34 is a polarization cancellation period when the polarization cancellation control is executed after the battery 10 is charged. In this example, the length of the period of time P34 is one tenth of the length of the period of time P23a. At time t4, the ECU 100 stops the external power supply control, and calculates SOC.

The ECU 100 calculates, as ΔSOC, the absolute value of the difference between SOC calculated at time t2 and SOC calculated at time t4, thereby estimating the full charge capacity.

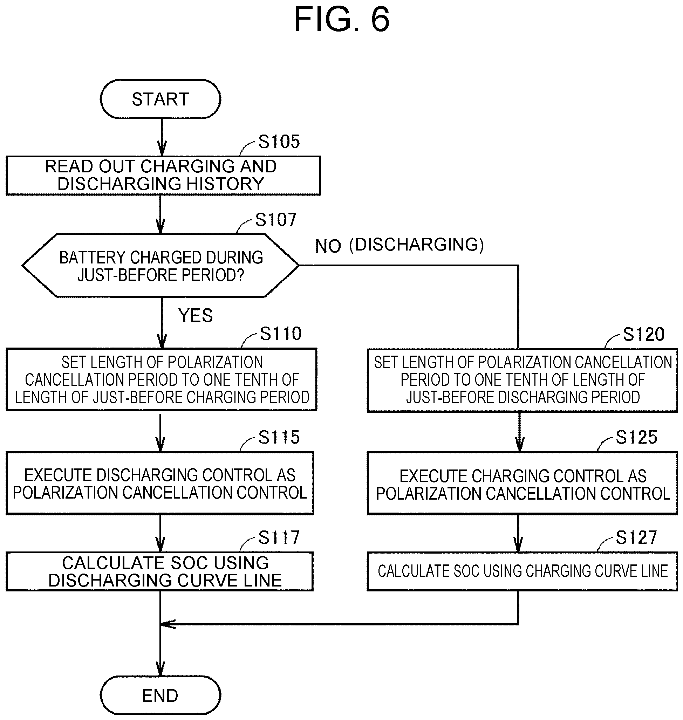

FIG. 6 is a flowchart showing an example of processing to be executed by the ECU 100 in connection with the calculation processing of SOC. This flowchart is started at the time when the vehicle 1 is plugged in.

Referring to FIG. 6, the ECU 100 reads out the charge/discharge history 110 (S105), and determines whether the battery 10 has been charged or discharged just before the current time (S107).

When the battery 10 has been charged just before (YES in S107), the ECU 100 sets the length of the polarization cancellation period to, for example, one tenth of the length of the just-before charging period (S110). The ECU 100 executes discharging control as the polarization cancellation control over a set period of time (S115). This discharging control corresponds to, for example, external power supply control during the period of time P34. After S115, the ECU 100 determines OCV (for example, V1a in FIGS. 4A and 4B) of the battery 10, and calculates SOC according to the OCV by using the line 220 (the discharging curve line) (S117). In this example, the SOC is calculated as Xa (FIGS. 4A and 4B).

When the battery 10 has been discharged just before (NO in S107), the ECU 100 sets the length of the polarization cancellation period to, for example, one tenth of the length of the just-before discharging period (S120). The ECU 100 executes charging control as the polarization cancellation control over a set period of time (S125). This charging control corresponds to, for example, the external charging control during the period of time P12. After S125, the ECU 100 determines OCV (for example, V1b in FIGS. 4A and 4B) of the battery 10, and calculates SOC according to the OCV by using the line 200 (charging curve line) (S127). In this example, the SOC is calculated as Xb (FIGS. 4A and 4B).

The ECU 100 may execute S105 to S127 while the vehicle 1 is running (while the motor 35 is being driven). In this case, the charging control and the discharging control are performed using PCU 30. Alternatively, the charging control may be the pumping charging control.

As described above, according to the embodiment, it is possible to avoid a situation where the calculation result of SOC is influenced by polarization. As a result, the SOC can be calculated with high accuracy.

### Modifications of Embodiment

In this modification, after the power running or regenerative electric power generation of the motor 35 is performed for a relatively long period of time while the vehicle 1 is running (when the just-before discharging period or the just-before charging period is long), a case where the ECU 100 performs charging control or discharging control using the PCU 30 is assumed.

In a case where one eleventh of the length of the just-before discharging period is less than 0.1 second and one ninth of the length of the just-before discharging period is 0.1 second or more, there is a possibility that the length of the polarization cancellation period (the period of time of the charging control) may be less than 0.1 second when the length of the polarization cancellation period is set to one eleventh or more and one ninth or less of the length of the just-before discharging period. The inventors have had a knowledge that when the length of this polarization cancellation period is less than 0.1 second, polarization is not always sufficiently canceled even by the polarization cancellation control (charging control). On the other hand, the inventors have had a knowledge that when the length of this polarization cancellation period is 0.1 second or more, polarization is particularly likely to be canceled sufficiently. Therefore, when one eleventh of the length of the just-before discharging period is less than 0.1 second and one ninth of the length of the just-before discharging period is 0.1 second or more, the ECU 100 may set the length of the polarization cancellation period to 0.1 second or more and one ninth or less of the length of the just-before discharging period.

When one eleventh of the length of the just-before charging period is less than 0.1 second and one ninth of the length of the just-before charging period is 0.1 second or more, there is a possibility that the length of the polarization cancellation period (the period of time of the discharging control) is less than 0.1 second when the length of the polarization cancellation period is set to one eleventh or more and one ninth or less of the length of the just-before charging period. The inventors have had a knowledge that when the length of this polarization cancellation period is less than 0.1 second, polarization is not always sufficiently canceled even by the polarization cancellation control (discharging control). On the other hand, the inventors have had a knowledge that when the length of this polarization cancellation period is 0.1 second or more, polarization is particularly likely to be canceled sufficiently. Therefore, when one eleventh of the length of the just-before charging period is less than 0.1 second and one ninth of the length of the just-before charging period is 0.1 second or more, the ECU 100 may set the length of the polarization cancellation period to 0.1 second or more and one ninth or less of the length of the just-before charging period.

When one ninth of the length of the just-before discharging period is less than 0.1 second, the length of the polarization cancellation period is always less than 0.1 second when the length of the polarization cancellation period is set to one eleventh or more and one ninth or less of the length of the just-before discharging period. In this case, as described above, polarization is not always sufficiently canceled even by the polarization cancellation control (charging control). Therefore, when one ninth of the length of the just-before discharging period is less than 0.1 second, the ECU 100 may set the length of the polarization cancellation period to 0.1 second or more (for example, 0.1 second).

When one ninth of the length of the just-before charging period is less than 0.1 second, the length of the polarization cancellation period is always less than 0.1 second when the length of the polarization cancellation period is set to one eleventh or more and one ninth or less of the length of the just-before charging period. In this case, as described above, polarization is not always sufficiently canceled even by the polarization cancellation control (discharging control). Therefore, when one ninth of the length of the just-before charging period is less than 0.1 second, the ECU 100 may set the length of the polarization cancellation period to 0.1 second or more (for example, 0.1 second).

### Other Modifications

Each cell of the battery 10 may be a liquid type battery such as a liquid type lithium ion battery. The polarization cancellation control and the calculation processing of SOC can also be applied to a battery system including a liquid type battery instead of an all-solid-state battery.

The embodiments disclosed herein should be considered to be illustrative in all respects and not to be restrictive. The scope of the present invention is indicated by the claims rather than the above description, and it is intended that all changes within the meaning and range equivalent to the claims are included.

## Claims

1. A battery system comprising:
a power storage device; and
a control device that executes polarization cancellation control for canceling polarization of the power storage device, and calculation processing for calculating SOC of the power storage device after the polarization cancellation control, wherein when the polarization cancellation control is executed after the power storage device is discharged, the polarization cancellation control is charging control for charging the power storage device, and when the polarization cancellation control is executed after the power storage device is charged, the polarization cancellation control is discharging control for discharging the power storage device.

2. The battery system according to claim 1, wherein when the polarization cancellation control is executed after the power storage device is discharged, the calculation processing is processing for calculating the SOC using an SOC-OCV characteristic of the power storage device under charging of the power storage device, and when the polarization cancellation control is executed after the power storage device is charged, the calculation processing is processing for calculating the SOC using an SOC-OCV characteristic of the power storage device under discharging of the power storage device.

3. The battery system according to claim 1 or 2, wherein assuming that a period of time during which the polarization cancellation control is executed is defined as a cancellation period, when the power storage device is charged just before the cancellation period, a period of time during which the power storage device is charged is defined as a just-before charging period, and when the power storage device is discharged just before the cancellation period, a period of time during which the power storage device is discharged is defined as a just-before discharging period, when the polarization cancellation control is executed after the power storage device is discharged, the cancellation period is shorter than the just-before discharging period, and when the polarization cancellation control is executed after the power storage device is charged, the cancellation period is shorter than the just-before charging period.

4. The battery system according to claim 3, wherein when the polarization cancellation control is executed after the power storage device is discharged, a length of the cancellation period is one eleventh or more and one ninth or less of a length of the just-before discharging period, and when the polarization cancellation control is executed after the power storage device is charged, the length of the cancellation period is one eleventh or more and one ninth or less of a length of the just-before charging period.

5. The battery system according to claim 4, wherein when one eleventh of the length of the just-before discharging period is less than 0.1 second and one ninth of the length of the just-before discharging period is 0.1 second or more, the length of the cancellation period is 0.1 second or more and one ninth or less of the length of the just-before discharging period, when one ninth of the length of the just-before discharging period is less than 0.1 second, the length of the cancellation period is 0.1 second, when one eleventh of the length of the just-before charging period is less than 0.1 second and one ninth of the length of the just-before charging period is 0.1 second or more, the length of the cancellation period is 0.1 second or more and one ninth or less of the length of the just-before charging period, and when one ninth of the length of the just-before charging period is less than 0.1 second, the length of the cancellation period is 0.1 second.
